(19) Europäisches Patentamt
European Patent Office
Office européen des brevets

(11) **EP 1 740 968 B1**

(12) **EUROPÄISCHE PATENTSCHRIFT**

(45) Veröffentlichungstag und Bekanntmachung des Hinweises auf die Patenterteilung:
**01.04.2009  Patentblatt 2009/14**

(21) Anmeldenummer: **05716457.6**

(22) Anmeldetag: **30.03.2005**

(51) Int Cl.:
***G01R 33/50*** (2006.01)

(86) Internationale Anmeldenummer:
**PCT/EP2005/003343**

(87) Internationale Veröffentlichungsnummer:
**WO 2005/101048 (27.10.2005 Gazette 2005/43)**

(54) **BILDGEBUNGSVERFAHREN SOWIE KERNSPINTOMOGRAPH ZUR ERFASSUNG DER LONGITUDINALEN SPIN-GITTER RELAXATIONSZEIT**

IMAGING PROCESS AND NUCLEAR SPIN TOMOGRAPH FOR SENSING LONGITUDINAL SPIN-LATTICE RELAXATION TIME

PROCEDE D'IMAGERIE ET TOMOGRAPHE A RESONANCE MAGNETIQUE POUR SAISIR LE TEMPS DE RELAXATION LONGITUDINAL SPIN-RESEAU

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **19.04.2004   DE 102004019394**

(43) Veröffentlichungstag der Anmeldung:
**10.01.2007   Patentblatt 2007/02**

(73) Patentinhaber: **Forschungszentrum Jülich Gmbh 52428 Jülich (DE)**

(72) Erfinder: **SHAH, N., Joni 52428 Jülich (DE)**

(74) Vertreter: **Jostarndt, Hans-Dieter Brüsseler Ring 51 52074 Aachen (DE)**

(56) Entgegenhaltungen:
**WO-A-01/94965**

• W. BLOCK AL.: "RARE spiral T2-weighted imaging" MAGNETIC RESONANCE IN MEDICINE, Bd. 37, April 1997 (1997-04), Seiten 582-590, XP000686621 ISSN: 0740-3194
• G. LU ET AL.: "Fast and high-resolution MRI on the basis of interleaved-spiral technique at 4.7 T and its application for imaging of ischemic rat brain" APPL. MAGN. RES., Bd. 25, 2003, Seiten 313-321, XP008049382 ISSN: 0937-9347
• R.J. ORDIDGE ET AL.: "HIGH-SPEED MULTISLICE T1 MAPPING USING INVERSION-RECOVERY ECHO-PLANAR IMAGING" MAGNETIC RESONANCE IN MEDICINE, Bd. 16, 1. November 1990 (1990-11-01), Seiten 238-245, XP000175905 ISSN: 0740-3194

**Beschreibung**

**Technisches Gebiet**

Die Erfindung betrifft ein Bildgebungsverfahren zur Erfassung der longitudinalen Spin-Gitter Relaxationszeit ($T_1$) mit mindestens einem Datenakquisitionsmodul, umfassend mindestens einen schichtselektiven $\alpha$-Hochfrequenzimpuls sowie magnetische Gradienten ($G_x$, $G_y$, $G_z$) zur Schichtselektion und/oder zur Codierung eines k-Raums, wobei akquirierte Daten einen Zeitpunkt einer Spin-Gitter Relaxation beschreiben und das Datenakquisitionsmodul zur Akquisition von Daten mindestens eines weiteren Zeitpunkts wiederholt wird, wobei ferner mindestens ein 180°-Hochfrequenzimpuls oder mindestens ein 180°-Hochfrequenzimpuls und mindestens ein dem 180°-Hochfrequenzimpuls vorgelagerter 90°-Hochfrequenzimpuls zur Erzeugung einer Spin-Gitter Relaxation dem ersten Datenakquisitionsmodul vorgeschaltet sind.

Die Erfindung betrifft ferner einen Kernspintomographen zur Quantifizierung der longitudinalen Spin-Gitter Relaxationszeit ($T_1$) mit einem Mittel zur Erzeugung von magnetischen Gradienten, einem Mittel zur Erzeugung von Hochfrequenzimpulsen, einem Mittel zur Datenakquisition und einem Mittel zur Erzeugung eines statischen Hauptmagnetfeldes.

**Stand der Technik**

Die grundlegenden Prinzipien der räumlich aufgelösten magnetischen Kernresonanz - die im Folgenden für das Verständnis der Erfindung zugrunde gelegt werden - sind beispielsweise in einer Monographie von P. Mansfield und P. G. Morris unter dem Titel "MMR Imaging in Biomedicine" (Academic Press, 1982) sowie in der Monographie von P. T. Callaghan unter dem Titel "Principles of Nuclear Magnetic Resonance Microscopy" (Clarendon Press, Oxford 1991, ISBN 0198539444) beschrieben. Ferner sind dem Lehrbuch "Magnetic Resonance Imaging" von E. Mark Haacke et al. (Wiley-Liss, 1999) detaillierte Beschreibungen zur kernmagnetischen Resonanz sowie zur kernmagnetischen Bildgebung zu entnehmen. Darüber hinaus finden sich in der vorgenannten Publikation von Haacke et al. technische und funktionelle Angaben zum Aufbau und Betrieb eines Kernspintomographen. Die vorliegende Anmeldung macht durch Referenz vom Inhalt der vorgenannten Publikationen sowie von den unten angeführten Publikationen des Standes der Technik vollständig Gebrauch.

Die quantitative Darstellung der Spin-Gitter Relaxationszeit $T_1$ spielte bisher nur eine untergeordnete Rolle in der klinischen Diagnostik, da die bisherigen Verfahren lange Erfassungszeiten benötigten und somit für eine Vielzahl an medizinischen Untersuchungen eine zu geringe zeitliche Auflösung aufweisen. Eine Möglichkeit zur Erfassung von vorwiegend $T_1$-gewichteten Signalen

stellt die *"snapshot FLASH"*-Methode von Deichmann und Kollegen (Journal of Magnetic Resonance, Vol. 96, S. 608-612, 1992) bereit. Jedoch benötigt diese *"snapshot FLASH"*-Methode, bedingt durch Wartezeiten zur Wiederherstellung der Ausgangsmagnetisierung, welche eine Gleichgewichtsmagnetisierung (auch makroskopische Magnetisierung genannt) sein kann, Erfassungszeiten im Bereich von 10 bis 30 Minuten. Im Falle hoher räumlicher Auflösung wird die zeitliche Auflösung zusätzlich beschränkt.

Zur Erhöhung der zeitlichen Auflösung entwickelten Ordidge und Kollegen eine schnellere Bildgebungsmethode als die vorgenannte *"snapshot FLASH"*-Methode zur Erfassung der vorwiegend $T_1$-gewichteten Signale auf Basis von echoplanarer Bildgebung (*"Inversion-Recovery EPI Method"*, Magnetic Resonance in Medicine, Vol. 16, S. 238-245, 1990), allerdings ist diese Methode bis heute nicht weit verbreitet, da die der echoplanar Bildgebung inhärenten Artefakte den Gebrauch als klinisch nicht akzeptabel erscheinen lassen. Insbesondere räumliche Verzerrungen von Kantenstrukturen von Objekten innerhalb der rekonstruierten Bilder, welche selbst durch eine Phasenkorrektur der erfassten Signale nicht gänzlich verhindert werden können, reduzieren die klinische Bedeutung des Verfahrens zur Generierung von vorwiegend $T_1$-gewichteten Bildern.

Den meisten der heute klinisch relevanten Bildgebungsmethoden zur Erfassung der vorwiegend $T_1$-gewichteten Signale liegt die ursprüngliche Arbeit von Look und Locker zugrunde (D. C. Look and D. R. Locker, The Review of Scientific Instruments, Vol. 41 Nr.2, S. 250-251, 1970).

Die Methode nach Look-Locker wendet nach erfolgter Inversion einer Ausrichtung der makroskopischen Magnetisierung mittels eines nicht-schichtselektiven 180°-Hochfrequenzimpulses, wobei die Ausrichtung vorzugsweise die eines Gleichgewichtszustandes ist, eine Vielzahl aufeinander folgender nicht-schichtselektiver $\alpha$-Hochfrequenzimpulse an. Mittels dieser nicht-schichtselektiver $\alpha$-Hochfrequenzimpulse werden Kernspins einer Probe während der longitudinalen Spin-Gitter Relaxation nach erfolgter Inversion der Magnetisierung angeregt, wobei Signale in Hochfrequenzspulen induziert werden, so dass Signal-Messungen zu mehr als einem Zeitpunkt während der Spin-Gitter Relaxation vorgenommen werden können. Dieses Vorgehen nutzt die relativ lange Zeit (- $5 \cdot T_1$) zur Wiederherstellung der Gleichgewichtsmagnetisierung in besonders effektiver Weise für zusätzliche Messungen aus.

Die Offenlegungsschrift DE 100 28 171 A1 offenbart eine gattungsgemäße Pulsfolge, einen Kernspintomographen und ein Bildgebungsverfahren zur Erfassung von vorwiegend $T_1$-gewichteten Signalen. Die Pulsfolge bzw. das Bildgebungsverfahren basieren auf der Look-Locker Methode und umfassen einen schichtselektiven $\alpha$-Hochfrequenzimpuls, einen vorgelagerten nicht-schichtselektiven 180°-Hochfrequenzimpuls, der zur Inversion der Ausrichtung der makroskopischen Magnetisierung verwendet wird, einen vorgelagerten nicht-schichtselektiven 90°-Hochfrequenzimpuls sowie magnetische Gradienten ($G_x, G_y, G_y$) zur k-Raum-Codierung und Schichtselektion. Die Besonderheit des Verfahrens nach DE 100 28 171 A1 besteht in einer zweckmäßigen Abfolge von Wiederholungen der schichtselektiven Anregung, gefolgt von der k-Raum-Codierung und der Datenakquisition, so dass nach Inversion der makroskopischen Magnetisierung eine Abfolge an vorwiegend $T_1$-gewichteten Signalen während einer Spin-Gitter Relaxation akquiriert wird.

Die vorgenannten Verfahren verbindet das Ziel, vorwiegend $T_1$-gewichtete Signale in klinischrelevanter Zeit zu akquirieren, wobei die rekonstruierten Schichtbilder eine hohe räumliche Auflösung aufweisen sollen. Die IR-EPI Methode von Ordidge et al. ist im Vergleich zum vorgenannten Verfahren nach DE 100 28 171 A1 schneller und weist somit eine höhere zeitliche Auflösung als das Verfahren nach DE 100 28 171 A1 auf, kann aber aufgrund der geringen räumlichen Auflösung sowie der nicht vernachlässigbaren inhärenten Artefakte der echoplanaren Bildgebungsmethode kaum in der klinischen Diagnostik eingesetzt werden.

Die Veröffentlichung W. Block et al., "RARE Spiral T2-Weighted Imaging", Mag. Res. Med 37: 582-590 (1997) beschreibt eine Datenakquisition mit einer spiralförmigen k-Raum-Trajektorie und einer RARE-Pulsfolge zur Erfassung von $T_2$-gewichteten Signalen. Die Pulsfolge umfasst periodische Refokussierungsspulse zur Refokussierung von Spins während einer langen Akquisitionszeit.

**Darstellung der Erfindung**

Ein wesentliches Anwendungsgebiet der Erfindung ist die nuklearmagnetische Resonanz (NMR) bzw. die Kernspintomographie. Die Erfindung lässt sich zudem aber auch auf eine Elektronenspinresonanz anwenden.

Der Erfindung liegt die Aufgabe zugrunde, ein gattungsgemäßes Bildgebungsverfahren bereitzustellen, welches vorwiegend $T_1$-gewichtete Bilder mit einem hohen Signal-zu-Rausch Verhältnis erzeugt. Ferner sollen die vorwiegend $T_1$-gewichteten Bilder eine hohe räumliche Auflösung aufweisen.

Der Erfindung liegt ferner die Aufgabe zugrunde, einen gattungsgemäßen Kernspintomographen bereitzustellen, der zur Durchführung des vorgenannten Bildgebungsverfahrens geeignet ist.

Erfindungsgemäß wird die vorgenannte Aufgabe in Verbindung mit dem Oberbegriff des Patentanspruchs 1 dadurch gelöst, dass nach dem schichtselektiven α-Hochfrequenzimpuls die magnetischen Gradienten $G_x$ und $G_y$ zur k-Raum-Codierung gleichzeitig geschaltet werden, wobei ein zeitlicher Verlauf der magnetischen Gradienten $G_x$ und $G_y$ sinusförmig erfolgt, so dass eine spiralförmige Bedeckung des k-Raumes resultiert, und wobei ferner Daten während der k-Raum-Codierung akquiriert werden.

Die Zeitabhängigkeit der Spin-Gitter Relaxation wird mit der Zeitkonstanten $T_1$ beschrieben. Ein der Erfassung der Zeitkonstanten zugrunde liegender zeitlicher Ablauf einer Regeneration einer longitudinalen Komponente der makroskopischen Magnetisierung weist im Wesentlichen einen mono-exponentiellen Verlauf auf. Das erfindungsgemäße Verfahren erlaubt zudem die Erfassung der Spin-Gitter Relaxationszeit, bei der der zeitliche Regenerationsablauf der longitudinalen Komponente der makroskopischen Magnetisierung bi- oder auch multi-exponentiell verläuft.

Der wichtige Vorteil des vorgenannten Verfahrens besteht in der zum Stand der Technik vergleichsweise schnellen Erfassung von vorwiegend $T_1$-gewichteten Signalen.
Erfassungszeiten im Bereich von wenigen Sekunden werden somit je nach Zahl N an Zeitpunkten ermöglicht. Beispielsweise können vorwiegend $T_1$-gewichtete Signale, die zu Bildern mit einer räumlichen Auflösung von 256 x 256 Bildelementen (Pixeln) zu 25 voneinander verschiedenen Zeitpunkten rekonstruiert werden können, in einer klinisch relevanten Zeit von ca. ½ Minute erfasst werden. Infolge der kurzen Erfassungszeiten ist dieses Verfahren insbesondere im Bereich routinemäßiger klinischer Untersuchungen anwendbar, insbesondere dort, wo zusätzlich zur geringen Erfassungszeit noch relativ kleine Schichtdicken im Bereich von 1 - 3 mm für die medizinische Diagnostik gewünscht werden. Bei einer entsprechenden Verringerung der räumlichen Auflösung ist es erfindungsgemäß möglich, Erfassungszeiten unter einer Minute zu erzielen und gleichzeitig ein hohes Signal-zu-Rausch Verhältnis der vorwiegend $T_1$-gewichteten Bilder zu gewährleisten.
Das hohe Signal-zu-Rausch Verhältnis ergibt sich beispielsweise aus der hohen Datenakquisitionsrate in der Nähe des Ursprungs des k-Raumes. Es ist allgemein bekannt, dass Daten im und am Ursprung des k-Raumes ein hohes Signal-zu-Rausch Verhältnis ausweisen, so dass ein entsprechend hohes Signal-zu-Rausch Verhältnis der vorwiegend $T_1$-gewichteten Bilder resultiert.

Ein weiterer Vorteil des erfindungsgemäßen Verfahrens liegt in einer Reduzierung des partiellen Volumeneffektes, wie er an den Bereichsübergängen von Bildelementen bzw. von Volumenelementen (Voxel) in rekonstruierten Bildern, insbesondere bei großen Schichtdicken, beobachtet wird. Der partielle Volumeneffekt resultiert aus einer Vermischung von unterschiedlichen Signalanteilen innerhalb eines Bildelementes im Falle von heterogenen Strukturen und somit im Falle von heterogenen Signalanteilen. Je größer die Schichtdicke, desto größer ist in der Regel der Anteil an heterogenen Signalanteilen, die zu geometrischen Verzerrungen der Bildelemente führen. Das erfindungsgemäße Bildgebungsverfahren ermöglicht die Datenakquisition von dünnen Schichten und liefert dennoch ein hohes Signal-zu-Rausch Verhältnis. Infolge dessen ist der Anteil an heterogenen Signalen innerhalb eines Bildelementes und somit der partielle Volumeneffekt sehr gering. Der geringe partielle Volumeneffekt führt unmittelbar zur erfindungsgemäßen Erhöhung der Genauigkeit der rekonstruierten vorwiegend $T_1$-gewichteten Bilder, die zu einer erhöhten Genauigkeit der erfassten longitudinalen Spin-Gitter Relaxationszeit $T_1$ führt.

Die magnetischen Gradienten $(G_x, G_y, G_y)$ verlaufen zweckmäßigerweise orthogonal zueinander im Raum, so dass gemäß eines funktionellen Zusammenhangs, $\underline{k} = -\gamma \int \underline{G}(t) dt$ zwischen einem resultierenden magnetischen Gradienten $\underline{G}$ und dem resultierenden Vektor $\underline{k}$ des k-Raumes, wobei $t$ eine Zeitabhängigkeit darstellt, eine Orthogonalität der Vektoren $k_x$, $k_y$, $k_z$ resultiert. Das griechische Symbol $\gamma$ repräsentiert ein gyromagnetisches Verhältnis zwischen dem magnetischen Drehmoment und dem Drehimpuls der zu untersuchenden Probe. Beispielsweise lässt sich das gyromagnetische Verhältnis von Protonen wie folgt angeben: $\gamma_H = 2\pi \times 42{,}5749 \times 10^6$ rad s$^{-1}$ T$^{-1}$. Eine dergestalte Festlegung auf ein kartesisches Koordinatensystem zur Beschreibung des k-Raumes ist zweckdienlich, aber zur Durchführung des Verfahrens nicht wesentlich. Vielmehr kann eine beliebige Beschreibung des k-Raumes gewählt werden, wobei im Bedarfsfall eine Transformation in das kartesische Koordinatensystem erfolgt.

Zweckmäßigerweise lässt sich der zeitliche Verlauf der Gradienten $G_x$ und $G_y$, der zur spiralförmigen Bedeckung des k-Raumes führt, mathematisch wie folgt beschreiben:

$$G_x(t) = \alpha_1 \sin(\alpha_2 t) + \alpha_1 \alpha_2 t \cos(\alpha_2 t)$$

$$G_y(t) = \alpha_1 \cos(\alpha_2 t) + \alpha_1 \alpha_2 t \sin(\alpha_2 t),$$

wobei die Werte für $\alpha_1$ und $\alpha_2$ unter Berücksichtigung des Nyquist-Kriteriums bestimmt werden. Die Gradienten sollten zweckmäßigerweise so geschaltet werden, dass sie in möglichst kurzer Zeit einen maximalen Wert erreichen.

Vorzugsweise führt der sinusförmige zeitliche Verlauf der magnetischen Gradienten $G_x$ und $G_y$ nach dem schichtselektiven $\alpha$-Hochfrequenzimpuls zu einer vollständigen spiralförmigen Bedeckung des k-Raumes. Somit kann bereits im Anschluss an den schichtselektiven $\alpha$-Hochfrequenzimpuls und nach erfolgter Datenakquisition der erfassten vorwiegend $T_1$-gewichteten Signale das vorwiegend $T_1$-gewichtete Bild einer Schicht, welches einen Zeitpunkt der Spin-Gitter Relaxation repräsentiert, rekonstruiert werden. Die Wiederholung des Datenakquisitionsmoduls zur Akquisition der Daten für mindestens einen weiteren Zeitpunkt, führt nach erfolgter Rekonstruktion zu einem weiteren vorwiegend $T_1$-gewichteten Bild derselben Schicht für den weiteren Zeitpunkt der Spin-Gitter Relaxation.

Zur Rekonstruktion werden die akquirierten Daten im Anschluss an die Datenakquisition und/oder während der Datenakquisition dergestalt bearbeitet, dass mit Mitteln der Fourier-Transformation (bzw. mit dem Mittel der schnellen Fourier-Transformation (FFT)) vorwiegend $T_1$-gewichtete Bilder zu N Zeitpunkten erzeugt werden können.

Infolge des sinusförmigen zeitlichen Verlaufs der magnetischen Gradienten werden erfasste analogdigital gewandelte Datenpunkte im k-Raum nicht auf einem kartesischen Raster abgelegt, vielmehr befinden sich die Datenpunkte entlang der spiralförmigen Bedeckung des k-Raumes. Zur Anwendung der schnellen Fourier-Transformation ist es erforderlich, die Datensätze dergestalt zu berechnen, dass die erfassten Datenpunkte im Anschluss an die Berechnung einem kartesischen Raster zugeordnet werden können.

Die Verfahren zur Bearbeitung (Umsortierung der Datensätze sowie Zuordnung des kartesischen Rasters) der akquirierten Daten sind dem Fachmann geläufig und können geeigneten Publikationen zu diesem Gebiet entnommen werden. Wahlweise kann zur weiteren Bearbeitung der akquirierten Daten oder der rekonstruierten Bilder anhand einer Phasenverlaufskarte eine Phasenkorrektur vorgenommen werden. Die Phasenverlaufskarte wird wahlweise aus den akquirierten Daten oder aus Daten einer weiteren Erfassung, bei der die Gradienten vorzugsweise nicht geschaltet werden, gebildet.

Die erzeugten vorwiegend $T_1$-gewichteten Bilder werden für eine anschließende Regressionsanalyse (Fitting) herangezogen, so dass im Anschluss an das Fitting die Zeitkonstante $T_1$ für jedes Bildelement (Pixel) des rekonstruierten Bildes der Schicht quantitativ vorliegt.

Es hat sich als besonders vorteilhaft erwiesen, den schichtselektiven $\alpha$-Hochfrequenzimpuls durch einen zwei-dimensionalen spektral sowie räumlich selektiven Hochfrequenzimpuls zu ersetzen. Ein dergestalter Hochfrequenzimpuls ist dem Fachmann geläufig und kann beispielsweise der Publikation von Meyer und Kollegen (C. H. Meyer et al.; Magnetic Resonance in Medicine; Vol. 15; Seiten 287 ff; 1990) entnommen werden. Ein besonders zweckmäßiger spektral sowie räumlich selektiver Hochfrequenzimpuls wird zur Unterdrückung von Protonensignalen von Fettmolekülen eingesetzt. Hierdurch werden insbesondere Off-Resonanzeffekte, beispielsweise hervorgerufen durch Interferenzen von Signalen von Protonen, welche Bestandteile von Fettmolekülen sind und solchen Protonensignalen, die nicht von Fettmolekülen herrühren, minimiert.

Eine besonders zweckmäßige Unterdrückung von Protonensignalen von Fettmolekülen ist in der Publikation von H. Moriguchi und Kollegen beschrieben (Magnetic Resonance in Medicine; Vol. 50; Seiten 915 ff; 2003), welche wahlweise innerhalb des erfindungsgemäßen Verfahrens angewendet wird. Entsprechend der Beschreibung erfolgt die Unterdrückung auf Basis von mindestens zwei aufeinander folgenden Datenakquisitionen, wobei jede Datenakquisition vorzugsweise zur vollständigen spiralförmigen Bedeckung des k-Raumes führt. Für jede dieser Datenakquisitionen wird ein Zeitintervall, auch bekannt als Echozeit $T_E$, ausgehend von einem zeitlichen Mittelpunkt des schichtselektiven $\alpha$-Hochfrequenzimpulses und endend am Beginn der einsetzenden Schaltung der magnetischen Gradienten zur k-Raum Codierung, festgelegt. Für die erste Datenakquisition wird das Zeitintervall auf $n\tau$ und für die folgende Datenakquisition auf $(n+1)\tau$ festgelegt, wobei n eine positive ganze Zahl ist und $\tau$ die Zeit beschreibt, in der die Kernspins der Protonen der Fettmoleküle eine Phasenänderung von 180° relativ zu den Protonen der Wassermoleküle erfahren haben. Aus den akquirierten Daten werden Phasen infolge von Off-Resonanzeffekten ermittelt und zur Korrektur von rekonstruierten Bildern verwendet.

Eine weitere vorteilhafte Minimierung von Off-Resonanzeffekten erfolgt unter Berücksichtigung der akquirierten Datenpunkte entlang der Koordinatenachsen des k-Raumes, bei denen zwei Koordinaten des k-Raums gleich Null sind. Abstände der Datenpunkte zueinander entlang der Koordinatenachse repräsentieren zumindest teilweise einen Einfluss von Off-Resonanzen. Je größer der Abstand der Datenpunkte zueinander, desto stärker ist der Einfluss der Off-Resonanzen während der Datenakquisition. Die akquirierten Datenpunkte werden im Bedarfsfall unter Berücksichtigung der den akquirierten Datenpunkten innewohnenden Phasen nach erfolgter Erfassung dergestalt transformiert, dass sie nach der Berechnung einen zueinander konstanten Abstand aufweisen. Gemäß der Bestimmung des zueinander konstanten Abstands und der anschließenden Transformation der Datenpunkte entlang der Koordinatenachsen werden die übrigen akquirierten Datenpunkte des k-Raumes transformiert, so dass sämtliche Datenpunkte einer spiralförmigen k-Raum Bedeckung nach der Transformation den konstanten Abstand zueinander in Richtungen parallel zu den Koordinatenachsen aufweisen.

Vorteilhafte Weiterbildungen des Verfahrens sind Gegenstand der Ansprüche 2 bis 5.

In einem bevorzugten Ausführungsbeispiel der Erfindung wird das Datenakquisitionsmodul zur Akquisition von Daten mindestens einer weiteren Schicht wiederholt. Zur Schichtselektion der weiteren Schicht werden die üblichen Techniken der bildgebenden Kernspintomographie eingesetzt - beispielsweise eine Modulation der Mittenfrequenz des Hochfrequenzimpulses. Darüber hinaus können sämtliche bekannten Verfahren der Schichtselektion eingesetzt werden.

Der Vorteil dieses Ausführungsbeispiels besteht in der schnellen Erfassung von vorwiegend $T_1$-gewichteten Signalen einer Zahl M an Schichten, die einen großen Volumenbereich abdecken. Beispielsweise kann der Volumenbereich des Gehirns eines Probanden in 48 Schichten geringer Dicke unterteilt werden. Diese Erweiterung der Dimensionalität der Datenakquisition umfasst weiterhin uneingeschränkt die Datenakquisition zu N Zeitpunkten, so dass nach erfolgter Erfassung der vorwiegend $T_1$-gewichteten Signale eine Zahl von mindestens N x M vorwiegend $T_1$-gewichteten Bildern einer Datenauswertung zur Verfügung steht. Hierdurch können beispielsweise vorwiegend $T_1$-gewichtete Bilder mit einer räumlichen Auflösung von 256 x 256 Pixeln für 48 Schichten zu 25 Zeitpunkten rekonstruiert werden, deren Erfassungszeit klinisch äußerst relevant ist (ca. 1 Minute).

In einem besonders bevorzugten Ausführungsbeispiel der Erfindung wird der magnetische Gradient $G_z$ zur weiteren k-Raum-Codierung mindestens abschnittsweise vor den magnetischen Gradienten $G_x$ und $G_y$ geschaltet, wobei der magnetische Gradient $G_z$ einen konstanten zeitlichen Verlauf während einer Schaltdauer aufweist. Hierdurch können vorwiegend $T_1$-gewichtete Signale mit einer vorgewählten Codierung in z-Richtung des k-Raumes erfasst werden, wobei die vorgewählte Codierung vorzugsweise durch geeignete Wahl einer Amplitude des magnetischen Gradienten $G_z$ erfolgt. Es hat sich als besonders vorteilhaft erwiesen, dass Datenakquisitionsmodul für eine gewählte Amplitude des magnetischen Gradienten $G_z$ N mal zu wiederholen, bevor eine weitere geänderte Wahl der Amplitude erfolgt.

Nach der Erzeugung einer weiteren Spin-Gitter Relaxation mittels des 180°-Hochfrequenzimpulses oder mittels des 180°-Hochfrequenzimpulses, dem der 90°-Hochfrequenzimpuls vorgelagert ist, wird die Amplitude des Gradienten $G_z$ innerhalb des Datenakquisitionsmoduls zur weiteren k-Raum-Codierung vorteilhafterweise so geschaltet, dass unterschiedliche $k_z$-Codierungen des k-Raumes nach jeweiliger Erzeugung einer weiteren Spin-Gitter Relaxation vorliegen. Entsprechend einer vorbestimmbaren Anzahl P wird dieser Vorgang wahlweise P mal wiederholt.

Nach erfolgter Erfassung der vorwiegend $T_1$-gewichteten Signale sowie im Anschluss an die Bearbeitung der Datenpunkte liegen mindestens P x N Datensätze vor, wobei jeder Datensatz innerhalb eines dreidimensionalen k-Raumes $(k_x, k_y, k_z)$ dargestellt werden kann. Jeder dieser drei-dimensionalen k-Räume weist eine arithmetische Spirale in der Ebene parallel zur durch die Vektoren $k_x$ und $k_y$ aufgespannten Fläche mit einem relativen Abstand vom Ursprung des k-Raumes in Richtung des $k_z$ Vektors auf. Der relative Abstand ist durch die der jeweiligen Erfassung zugrunde zu legenden Amplitude des magnetischen Gradienten $G_z$ bestimmt.

In einer besonders zweckmäßigen Ausführungsform wird der magnetische Gradient $G_z$ zur weiteren k-Raum-Codierung mindestens abschnittsweise gleichzeitig mit den magnetischen Gradienten $G_x$ und $G_y$ geschaltet und weist hierbei einen konstanten zeitlichen Verlauf während einer Schaltdauer auf.

Es hat sich ferner als besonders vorteilhaft erwiesen, das Datenakquisitionsmodul für eine gewählte Amplitude des magnetischen Gradienten $G_z$ N mal zu wiederholen, bevor eine weitere Wahl der Amplitude erfolgt.

Zudem wird die Amplitude des Gradienten $G_z$ innerhalb des weiteren Akquisitionsmoduls nach der Erzeugung einer weiteren Spin-Gitter Relaxation vorteilhafterweise so geschaltet, dass unterschiedliche $k_z$-Codierungen des k-Raumes nach jeweiliger Erzeugung einer weiteren Spin-Gitter Relaxation vorliegen. Dieser Vorgang wird wahlweise P mal wiederholt.

Bei dieser Ausführungsform erfolgt eine weitere Erhöhung der zeitlichen Auflösung durch die Akquisition von Volumendatensätzen innerhalb eines Datenakquisitionsmoduls. Nach erfolgter Erfassung der vorwiegend $T_1$-gewichteten Signale sowie im Anschluss an die Bearbeitung der Datenpunkte liegen mindestens P x N Volumendatensätze vor, wobei jeder Volumendatensatz einen drei-dimensionalen k-Raum repräsentiert. Jeder dieser k-Räume wird mit einer drei-dimensionalen Spirale beschrieben, welche sich vorzugsweise in Richtung des $k_z$ Vektors verjüngt. Ein Verjüngungsgrad ergibt sich aus der jeweils zugrunde zu legenden Amplitude des magnetischen Gradienten $G_z$.

Wahlweise werden weitere Ausgestaltungen an zeitlichen Verläufen der magnetischen Gradienten eingesetzt, die zu weiteren Beschreibungen des k-Raumes führen. Beispielsweise kann der k-Raum durch eine drei-dimensionale Spirale beschrieben werden, welche mit zunehmendem $k_z$ Vektor einen zunehmenden Durchmesser aufweist.

Bei der repräsentativen Darstellung des Volumendatensatzes mittels des drei-dimensionalen k-Raums ergibt sich ein Öffnungswinkel der drei-dimensionalen Spirale mindestens durch die Amplitude des magnetischen Gradienten $G_z$. Für den Fall, dass nach der Bearbeitung der akquirierten Daten äußere - durch das Nyquist-Theorem bestimmte - Bereiche des k-Raumes nicht mit Datenpunkten besetzt werden, können die Bereiche fehlender Datenpunkte wahlweise mit Nullen besetzt werden, was nach erfolgter Fourier-Transformation einer Interpolation der Datensätze gleichkommt.

In einer weiteren vorteilhaften Ausführungsform der Erfindung erfolgt innerhalb des Datenakquisitionsmoduls durch eine Änderung der Phase mindestens eines der magnetischen Gradienten $G_x$ und $G_y$ eine weitere k-Raum-Codierung. Die Phasenänderung bezieht sich auf eine komplexwertige mathematische Darstellung der magnetischen Gradienten.

Durch die Phasenänderung wird es ermöglicht, mehrere ineinander geschachtelte spiralförmige Bedeckungen des k-Raumes zu erzielen, wobei die spiralförmigen Bedeckungen eines k-Raumes mindestens abschnittsweise in einem konstanten Abstand zueinander verlaufen und nur im Ursprung des k-Raumes konvergieren.

Zweckmäßigerweise wird das Datenakquisitionsmodul vor einer weiteren Erzeugung der Spin-Gitter Relaxation mindestens I mal wiederholt, wobei die Phase mindestens eines der magnetischen Gradienten $G_x$ und $G_y$ mit jeder Wiederholung variiert wird, so dass im Anschluss an den Wiederholungszyklus I ineinander geschachtelte spiralförmige Bedeckungen des k-Raumes vorliegen.

Der Vorteil der ineinander geschachtelten Bedeckungen des k-Raumes liegt beispielsweise in einer Reduzierung einer maximalen Gradientenleistung. Im Falle von I Wiederholungen reduziert sich die benötigte Gradientenleistung um einen Faktor von $1/(I^2)$. Gleichzeitig reduziert sich eine Frequenzbandbreite der Erfassung um den Faktor $1/(I)$, wobei sich das Signal-zu-Rausch Verhältnis im Vergleich zur einfachen spiralförmigen Bedeckung des k-Raumes um den Faktor $\sqrt{(I)}$ vergrößert.

Die Reduktion der maximalen Gradientenleistung ermöglicht es zudem, kommerzielle Gradientensysteme mit moderaten Leistungsdaten einzusetzen.

Es hat sich ferner als besonders zweckmäßig erwiesen, zumindest die ineinander geschachtelte spiralförmige Bedeckung des k-Raumes im Bereich der kardiologischen Diagnostik einzusetzen, da physiologische Stimulationen (z. B. eine elektromechanische Stimulation der Muskulatur) infolge der reduzierten Gradientenleistung ausbleiben. Zudem hat es sich als vorteilhaft erwiesen, eine elektrokardiographische (EKG) Triggerung der Erfassung der vorwiegend $T_1$-gewichteten Signale einzusetzen, so dass die Erfassung nur zu bestimmten Zyklen eines Herzrhythmus erfolgt. Die Erfassung von vorwiegend $T_1$-gewichteten Signalen kann mittels der ineinander geschachtelten spiralförmigen Bedeckung des k-Raumes besonders vorteilhaft im Bereich der Koranarangiographie eingesetzt werden.

Erfindungsgemäß wird die vorgenannte Aufgabe durch einen Kernspintomographen in Verbindung mit dem Oberbegriff des Patentanspruchs 6 dadurch gelöst, dass eine Steuerelektronik ein Bildgebungsverfahren nach einem der Ansprüche 1 bis 6 erzeugt.

Der erfindungsgemäße Kernspintomograph ist mit einer Steuerelektronik ausgestattet, welche die Erzeugung der erfindungsgemäßen Pulssequenz ermöglicht.

Hierdurch wird ein Kernspintomograph zur Verfügung gestellt, der zur Erfassung von vorwiegend $T_1$-gewichteten Signalen in klinisch relevanten Erfassungszeiten eingesetzt werden kann. Der erfindungsgemäße Kernspintomograph ist ferner äußerst kompakt gebaut und verfügt über Außenabmessungen, die den Einsatz in herkömmlichen Arztpraxen sowie in Kliniken ermöglicht. Wahlweise kann das Mittel zur Erzeugung des Hauptmagnetfeldes zur Generierung von Hauptmagnetfeldern von bis zu 12 Tesla eingesetzt werden. Folglich können anatomische Bilder von Probanden unter dem Einfluss eines Hochmagnetfeldes erzeugt werden, die quantitative Angaben zur Spin-Gitter Relaxationszeit ($T_1$) beinhalten. Ferner ermöglicht der erfindungsgemäße Kernspintomograph schnelle Schaltwechsel der Gradienten zur k-Raum-Codierung sowie zur Schichtanregung sowie hohe Gradientenleistungen, wobei die Gradienten wahlweise den sinusförmigen und/oder einen rechteckförmigen zeitlichen Verlauf innerhalb des Datenakquisitionsmoduls aufweisen. Vorteilhafterweise erfolgt eine Interpolation der akquirierten Daten bereits während der Akquisition, wobei die Daten infolge des sinusförmigen zeitlichen Verlaufes der magnetischen Gradienten von einem nicht-linearen Akquisitionsraster auf ein lineares Raster interpoliert werden.

In einer bevorzugten Ausführungsform verfügt der Kernspintomograph über ein Mittel zur Umsortierung der Datensätze sowie zur Zuordnung der akquirierten Daten zu einem kartesischen Raster sowie über Mittel zur Fourier-Rekonstruktion.

Hierdurch können vorteilhafterweise die umsortierten sowie zugeordneten Daten mittels herkömmlicher Fourier-Transformation in einen Bildraum überführt werden, so dass vorwiegend $T_1$-gewichtete Bilder resultieren.

Weitere Vorteile, Besonderheiten und zweckmäßige Weiterbildungen der Erfindung ergeben sich aus der nachfolgenden Darstellung bevorzugter Ausführungsbeispiele anhand der Abbildungen.

**Beschreibung der Abbildungen**

Von den Abbildungen zeigt:

Figur 1:    Prinzipdarstellung einer Gradientenfolge sowie einer Hochfrequenz- impulsfolge eines Ausführungsbeispiels des erfindungsgemäßen Bild- gebungsverfahrens.

Figur 2:    Schematische Darstellung einer vorteilhaften Abfolge an Wiederho- lungen des Datenakquisitionsmoduls mit einer beispielhaften Darstel- lung einer spiralförmigen Bedeckung einer Ebene des k-Raumes.

Figur 3:    Prinzipdarstellung einer Gradientenfolge sowie einer Hochfrequenz- impulsfolge eines weiteren bevorzugten Ausführungsbeispiels des er- findungsgemäßen Bildgebungsverfahrens.

Figur 4:    Schematische Darstellung von spiralförmigen Bedeckungen des k- Raumes entsprechend dem Ausführungsbeispiel nach Fig. 3.

Figur 5:    Prinzipdarstellung einer Gradientenfolge sowie einer Hochfrequenz- impulsfolge eines weiteren besonders bevorzugten Ausführungsbei- spiels des erfindungsgemäßen Bildgebungsverfahrens.

Figur 6:    Schematische Darstellung von spiralförmigen Bedeckungen des k- Raumes entsprechend dem Ausführungsbeispiel nach Fig. 5.

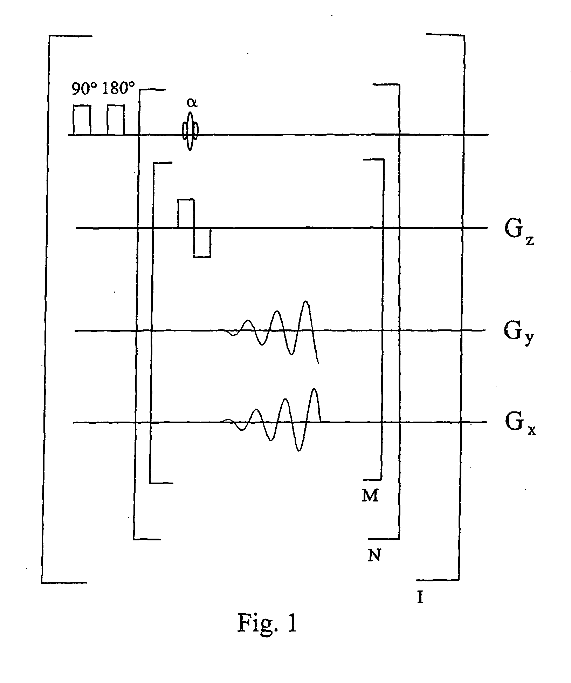

Figur 1 zeigt den prinzipiellen Ablauf einer Gradientenfolge sowie einer Hochfrequenzimpulsfolge eines Ausführungsbeispiels des erfindungsgemäßen Bildgebungsverfahrens.

Zunächst wird eine zu untersuchende Probe dem statischen Hauptmagnetfeld ausgesetzt, wobei sich die makroskopische Magnetisierung ausbildet und parallel zum Verlauf des Hauptmagnetfeldes ausrichtet, was der Ausrichtung des Gleichgewichtszustandes entspricht. In diesem Gleichgewichtszustand ist eine transversale Komponente der makroskopischen Magnetisierung klein oder gleich Null.

Der applizierte nicht-schichtselektive 90°-Hochfrequenzimpuls saturiert die makroskopische Magnetisierung. Die Erfassungszeit von Daten hängt theoretisch zumindest vom Leistungsumfang des verwendeten Gradientensystems, von etwaigen physiologischen Faktoren der zu untersuchenden Probe (elektrophysiologische Reizschwelle der Muskulatur etc.) sowie von der Zeitkonstanten $T_1$ der zu untersuchenden Probe ab. Das Vorschalten des nicht-schichtselektiven 90°-Hochfrequenzimpulses ist vorteilhaft, da auch nach einer Vielzahl von nicht-schichtselektiven Anregungen ein jeweils gleicher Betrag der durch den anschließenden 180°-Hochfrequenzimpuls invertierten makroskopischen Magnetisierung zu Beginn des ersten schichtselektiven $\alpha$-Hochfrequenzimpulses im Anschluss an die Inversion vorliegt. Hierdurch kann die Erfassungszeit deutlich reduziert werden.

Nach einer frei-wählbaren Regenerationsdauer, während der sich die makroskopische Magnetisierung wieder in Richtung des Gleichgewichtszustands ausbildet, invertiert der nicht-schichtselektive 180°-Hochfrequenzimpuls die makroskopische Magnetisierung, so dass sich die Longitudinalkomponente der makroskopischen Magnetisierung am Ende der Applikation des Hochfrequenzimpulses anti-parallel zur Richtung des Hauptmagnetfeldes erstreckt. Aufgrund von energetischen Wechselwirkungen der atomaren Bestandteile - der Kernspins - der makroskopischen Magnetisierung mit ihrer Umgebung erfolgt die Spin-Gitter Relaxation, welche zur zeitabhängigen Regeneration der ursprünglichen Ausrichtung der makroskopischen Magnetisierung parallel zum statischen Hauptmagnetfeld führt.

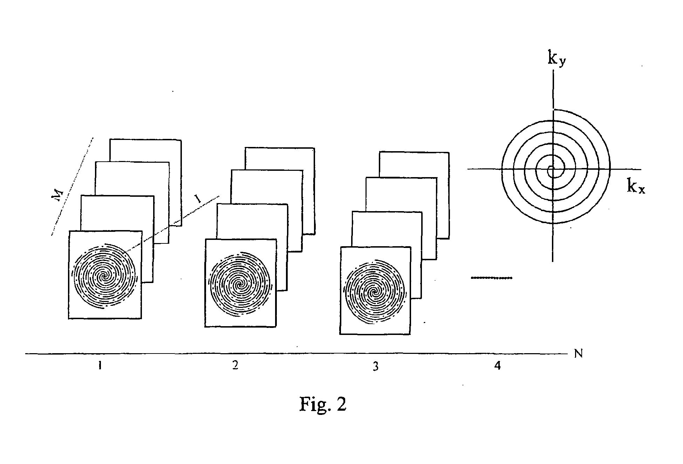

Im Anschluss an die nicht-schichtselektive Inversion der makroskopischen Magnetisierung wird eine erste Schicht der Probe durch die Anregung der Kernspins mittels des schichtselektiven $\alpha$-Hochfrequenzimpulses gewählt. Der $\alpha$-Hochfrequenzimpuls nutzt einen Teil der Longitudinalkomponente der makroskopischen Magnetisierung zur Generierung der Transversalkomponente der makroskopischen Magnetisierung. Nach der schichtselektiven Anregung werden die magnetischen Gradienten $G_x$ und $G_y$ zur k-Raum-Codierung gleichzeitig geschaltet. Der zeitliche Verlauf der magnetischen Gradienten $G_x$ und $G_y$ erfolgt sinusförmig und mit steigender Amplitude. Die Datenakquisition des vorwiegend $T_1$-gewichteten Signals erfolgt hierbei in Anwesenheit der magnetischen Gradienten $G_x$ und $G_y$. Ein Verlauf einer resultierenden ersten spiralförmigen Bedeckung des k-Raumes kann exemplarisch der Darstellung der Ebene des k-Raumes aus Figur 2 entnommen werden.

Am Ende des Schaltzyklus der magnetischen Gradienten $G_x$ und $G_y$ ist die Datenakquisition der Bedeckung abgeschlossen. Die akquirierten vorwiegend $T_1$-gewichteten Signale weisen im Mittel einen Kontrast in Abhängigkeit von der zur Verfügung stehenden Longitudinalkomponente auf.

Im Anschluss an die Datenakquisition der ersten Bedeckung des k-Raumes erfolgt mittels einer erneuten Anwendung des schichtselektiven α-Hochfrequenzimpulses die Schichtselektion einer weiteren Schicht, gefolgt von derselben k-Raum-Codierung wie zuvor. Nach einer dergestalten wiederholten Akquisition von vorwiegend $T_1$-gewichteten Signalen gleicher k-Raumcodierung für eine vorbestimmte Anzahl (M) unterschiedlicher Schichten wird wiederum die erste Schicht der Probe durch den schichtselektiven α-Hochfrequenzimpuls angeregt, wobei die Datenakquisition von weiteren Signalen derselben k-Raum-Codierung erfolgt. Nach diesem Schema werden nach der Inversion der makroskopischen Magnetisierung Daten bei gleich bleibender k-Raum-Codierung für M Schichten und zu N voneinander verschiedenen Zeitpunkten relativ zum Inversionszeitpunkt akquiriert.

Im Anschluss an die Datenakquisition der Signale von M Schichten zu N Zeitpunkten erfolgt eine weitere nicht-schichtselektive Inversion der makroskopischen Magnetisierung durch eine erneute Applikation des nicht-schichtselektiven 90°-Hochfrequenzimpulses gefolgt vom nicht-schichtselektiven 180°-Hochfrequenzimpuls im zeitlichen Abstand der Regenerationsdauer. Nach erfolgter Anregung der ersten Schicht mittels des schichtselektiven α-Hochfrequenzimpulses werden wiederum die magnetischen Gradienten $G_x$ und $G_y$ zur k-Raum-Codierung gleichzeitig geschaltet. Der zeitliche Verlauf der magnetischen Gradienten $G_x$ und $G_y$ erfolgt sinusförmig und mit steigender Amplitude, wobei die Phase mindestens eines der magnetischen Gradienten $G_x$ und $G_y$ zur weiteren k-Raum-Codierung geändert wurde.

Sukzessive werden nun die Daten einer weiteren k-Raum Bedeckung für wiederum M Schichten und zu N Zeitpunkten akquiriert.

Figur 2 zeigt eine schematische Darstellung der vorgenannten Abfolge an Wiederholungen des Datenakquisitionsmoduls mit der beispielhaften Darstellung der spiralförmigen Bedeckung einer Ebene des k-Raumes. Die waagerechte nummerierte Linie in Figur 2 repräsentiert den jeweiligen Erfassungszeitpunkt N, und die hintereinander geschachtelten schematisierten Darstellungen der k-Raum-Ebenen repräsentieren die Datenakquisitionen für M Schichten. Die durchgezogene Linie sowie die strichpunktierte Linie veranschaulichen unterschiedliche Bedeckungen (I) des k-Raumes.

Eine nach Abschluss einer vollständigen Erfassung erfolgende Bearbeitung der akquirierten Datensätze führt zu jeweils vollständigen Datensätzen der k-Räume von M Schichten zu N Zeitpunkten mit I Bedeckungen.

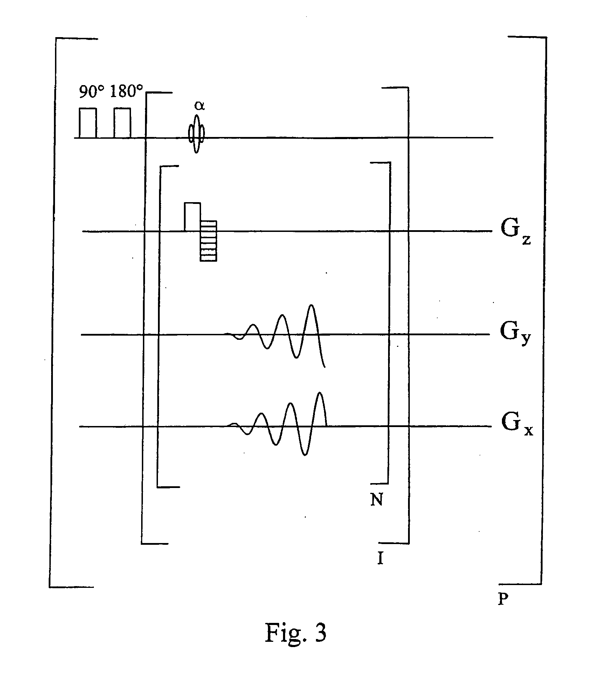

Figur 3 stellt das Prinzip der Gradientenfolge sowie der Hochfrequenzimpulsfolge des bevorzugten Ausführungsbeispiels des erfindungsgemäßen Bildgebungsverfahrens dar.

Das weitere bevorzugte Ausführungsbeispiel unterscheidet sich vom vorgenannten Ausführungsbeispiel nach den Figuren 1 und 2 dadurch, dass der magnetische Gradient $G_z$ zur weiteren k-Raum-Codierung nach erfolgter Schichtselektion durch den α-Hochfrequenzimpuls vor den magnetischen Gradienten $G_x$ und $G_y$ geschaltet wird. Der magnetische Gradient $G_z$ weist einen konstanten zeitlichen Verlauf während einer Schaltdauer auf. Das Datenakquisitionsmodul wird für die gewählte Amplitude des magnetischen Gradienten $G_z$ N x I mal wiederholt, bevor die weitere Abfolge an Saturierung und Inversion der makroskopischen Magnetisierung durch den 90°-Hochfrequenzimpuls sowie durch den anfolgenden 180°-Hochfrequenzimpuls erfolgt. Für jede gewählte $k_z$-Codierung ergeben sich folglich I Bedeckungen zu N Zeitpunkten.

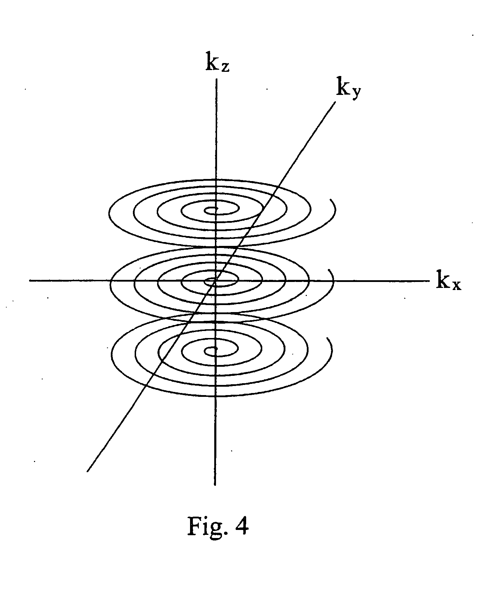

Figur 4 zeigt eine überlagerte Darstellung von 3 drei-dimensionalen k-Räumen mit 3 arithmetischen Spiralen in Ebenen parallel zur durch die Vektoren $k_x$ und $k_y$ aufgespannten Fläche für jeweils 3 voneinander verschiedenen $k_z$-Codierungen. Eine derartige überlagerte Darstellung repräsentiert 3 Wiederholungen des Datenakquisitionsmoduls des Ausführungsbeispiels nach Figur 3.

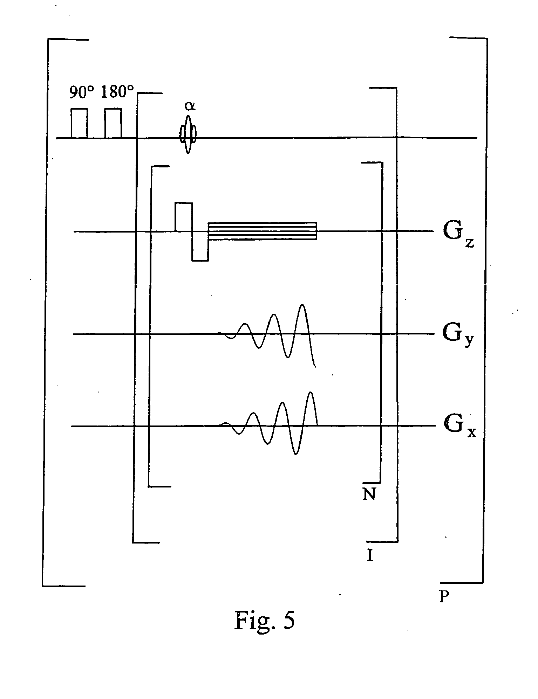

Figur 5 zeigt das Prinzip der Gradientenfolge sowie der Hochfrequenzimpulsfolge des besonders bevorzugten Ausführungsbeispiels des erfindungsgemäßen Bildgebungsverfahrens.

Beim besonders bevorzugten Ausführungsbeispiel wird der magnetische Gradient $G_z$ nach erfolgter Schichtselektion durch den α-Hochfrequenzimpuls zur weiteren k-Raum-Codierung gleichzeitig mit den magnetischen Gradienten $G_x$ und $G_y$ geschaltet und weist ferner einen konstanten zeitlichen Verlauf während einer Schaltdauer auf. Das Datenakquisitionsmodul wird für die gewählte Amplitude des magnetischen Gradienten $G_z$ N x I mal wiederholt, bevor eine weitere Wahl der Amplitude erfolgt. Die Amplitude des Gradienten $G_z$ wird innerhalb der weiteren Wiederholungen des Akquisitionsmoduls nach der Erzeugung einer weiteren Spin-Gitter Relaxation so geschaltet, dass unterschiedliche $k_z$-Codierungen des k-Raumes nach jeweiliger Erzeugung einer weiteren Spin-Gitter Relaxation vorliegen. Dieser Vorgang wird P mal wiederholt.

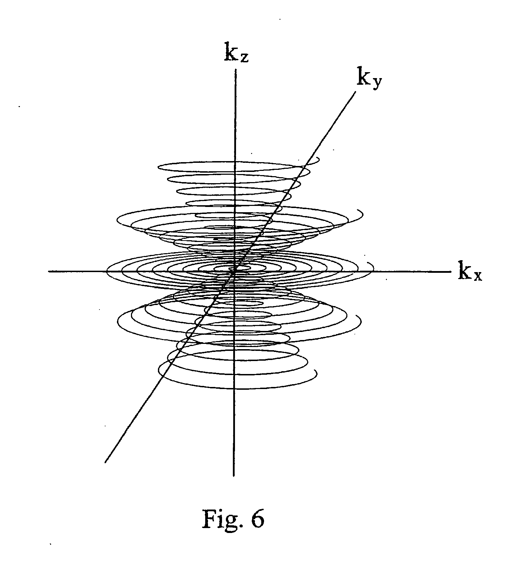

Figur 6 zeigt eine repräsentative Darstellung von Volumendatensätzen anhand eines drei-dimensionalen k-Raums. Die unterschiedlichen Öffnungswinkel der drei-dimensionalen Spirale ergeben sich infolge von 5 unterschiedlichen Amplituden des magnetischen Gradienten $G_z$.

Anhand von Fig. 6 lässt sich illustrativ entnehmen, dass im Falle von Volumendatensätzen unterschiedlicher Amplituden des magnetischen Gradienten $G_z$ äußere - durch das Nyquist-Theorem bestimmte - Bereiche des k-Raumes nicht mit Datenpunkten besetzt werden. Wahlweise können die äußeren Bereiche des Datenvolumens, in denen keine Datenpunkte akquiriert wurden, mit Nullen besetzt werden, woraufhin die Anwendung einer Fourier-Transformation ermöglicht wird.

**Patentansprüche**

1. Bildgebungsverfahren zur Erfassung der longitudinalen Spin-Gitter Relaxationszeit ($T_1$), mit mindestens einem Datenakquisitionsmodul, umfassend mindestens einen schichtselektiven $\alpha$-Hochfrequenzimpuls sowie magnetische Gradienten ($G_x$, $G_y$, $G_z$) zur Schichtselektion und/oder zur Codierung eines k-Raums, wobei akquirierte Daten einen Zeitpunkt einer Spin-Gitter Relaxation beschreiben und das Datenakquisitionsmodul zur Akquisition von Daten mindestens eines weiteren Zeitpunkts wiederholt wird, wobei ferner dem ersten Datenakquisitionsmodul mindestens ein 180°-Hochfrequenzimpuls oder mindestens ein 180°-Hochfrequenzimpuls und mindestens ein dem 180°-Hochfrequenzimpuls vorgelagerter 90°-Hochfrequenzimpuls zur Erzeugung einer Spin-Gitter Relaxation vorgeschaltet sind, **dadurch gekennzeichnet,** **dass** nach dem schichtselektiven $\alpha$-Hochfrequenzimpuls die magnetischen Gradienten $G_x$ und $G_y$ zur k-Raum-Codierung gleichzeitig geschaltet werden, wobei ein zeitlicher Verlauf der magnetischen Gradienten $G_x$ und $G_y$ sinusförmig und mit ansteigender Amplitude erfolgt, so dass eine spiralförmige Bedeckung des k-Raumes resultiert, und dass k-Raumcodierte Daten während der Anwesenheit der Gradienten $G_x$ und $G_y$ akquiriert werden.

2. Verfahren nach Anspruch 1, **dadurch gekennzeichnet,** **dass** das Datenakquisitionsmodul zur Akquisition von Daten mindestens einer weiteren Schicht wiederholt wird.

3. Verfahren nach einem der Ansprüche 1 oder 2, **dadurch gekennzeichnet,** **dass** der magnetische Gradient $G_z$ zur weiteren k-Raum-Codierung mindestens abschnittsweise vor den magnetischen Gradienten $G_x$ und $G_y$ geschaltet wird und einen konstanten zeitlichen Verlauf während einer Schaltdauer aufweist.

4. Verfahren nach einem der Ansprüche 1 oder 2, **dadurch gekennzeichnet,** **dass** der magnetische Gradient $G_z$ zur weiteren k-Raum-Codierung mindestens abschnittsweise gleichzeitig mit den magnetischen Gradienten $G_x$ und $G_y$ geschaltet wird und einen konstanten zeitlichen Verlauf während einer Schaltdauer aufweist.

5. Verfahren nach einem oder mehreren der vorgenannten Ansprüche, **dadurch gekennzeichnet,** **dass** innerhalb des Datenakquisitionsmoduls eine weitere k-Raum-Codierung durch eine Änderung der Phase mindestens eines der magnetischen Gradienten $G_x$ und $G_y$ erfolgt.

6. Kernspintomograph zur Quantifizierung der longitudinalen Spin-Gitter Relaxationszeit ($T_1$), mit einem Mittel zur Erzeugung von magnetischen Gradienten, einem Mittel zur Erzeugung von Hochfrequenzimpulsen, einem Mittel zur Signalakquisition und einem Mittel zur Erzeugung eines statischen Magnetfeldes, **dadurch gekennzeichnet,** **dass** eine Steuerelektronik ein Bildgebungsverfahren nach einem der Ansprüche 1 bis 5 erzeugt.

7. Kernspintomograph nach Anspruch 6, **dadurch gekennzeichnet,** **dass** er über ein Mittel zur Umsortierung und Interpolation der akquirierten Daten sowie über Mittel zur Fourier-Rekonstruktion verfügt.

**Claims**

1. An imaging method for the acquisition of the longitudinal spin-lattice relaxation time ($T_1$), with at least one data acquisition module, comprising at least one layer-selective $\alpha$ high-frequency pulse as well as magnetic gradients ($G_x$, $G_y$, $G_z$) for layer selection and/or for encoding a k-space, the acquired data describing a point in time of a spin-lattice relaxation and the data acquisition module for the acquisition of data of at least one additional point in time is repeated, wherein furthermore, the first data acquisition module is preceded by at least one 180° high-frequency pulse or else by at least one 180° high-frequency pulse with at least one 90° high-frequency pulse preceding the 180° high-frequency pulse, **characterized in that,** after the layer-selective $\alpha$ high-frequency pulse, the magnetic gradients $G_x$ and $G_y$ are actuated simultaneously for purposes of the k-space encoding, the magnetic gradients $G_x$ and $G_y$ following a sinusoidal time course with a rising amplitude, so that the result is a spiral-shaped coverage of the k-space; and **in that** k-space-encoded data is acquired during the presence of the gradients $G_x$ and $G_y$.

2. The method according to Claim 1, **characterized in that** the data acquisition module is repeated for the acquisition of data of at least one additional layer.

3. The method according to Claim 1 or Claim 2, **characterized in that,** for purposes of further k-space encoding, the magnetic gradient $G_z$ is actuated, at least in sections, before the magnetic gradients $G_x$ and $G_y$, and it has a constant time course during one actuation period.

4. The method according to one of Claims 1 or 2, **characterized in that,**
for purposes of further k-space encoding, the magnetic gradient $G_z$ is actuated, at least in sections, simultaneously with the magnetic gradients $G_x$ and $G_y$, and it has a constant time course during one actuation period.

5. The method according to one or more of the preceding claims, **characterized in that,**
within the data acquisition module, an additional k-space encoding takes place by changing the phase of at least one of the magnetic gradients $G_x$ and $G_y$.

6. A magnetic resonance imaging scanner for quantifying the longitudinal spin-lattice relaxation time ($T_1$), having a means for generating magnetic gradients, a means for generating high-frequency pulses, a means for signal acquisition and a means for generating a static magnetic field, **characterized in that**
control electronics generate an imaging method according to any of Claims 1 to 5.

7. The magnetic resonance imaging scanner according to Claim 6, **characterized in that**
it has means for re-sorting and interpolating the acquired data as well as means for a Fourier reconstruction.

**Revendications**

1. Procédé d'imagerie pour saisir le temps de relaxation longitudinal spin-réseau ($T_1$), comportant au moins un module d'acquisition de données comprenant au moins une impulsion haute fréquence $\alpha$ à sélection de couches ainsi que des gradients magnétiques ($G_x$, $G_y$, $G_z$) pour la sélection de couches et/ou pour le codage d'un espace k, des données acquises décrivant un point temporel d'une relaxation spin-réseau et le module d'acquisition de données étant répété, pour l'acquisition de données d'au moins un autre point temporel, en outre, au moins une impulsion haute fréquence de 180° ou au moins une impulsion haute fréquence de 180° et au moins une impulsion haute fréquence de 90° précédant l'impulsion haute fréquence de 180° précédent en outre le premier module d'acquisition de données pour générer une relaxation spin-réseau, **caractérisé en ce que**
après l'impulsion haute fréquence $\alpha$ à sélection de

couches les gradients magnétiques $G_x$ et $G_y$ sont connectés simultanément aux fins du codage de l'espace k, un tracé temporel des gradients magnétiques $G_x$ et $G_y$ se présentant sous une forme sinusoïdale et avec une amplitude croissante de sorte qu'il en résulte une couverture en forme de spirale de l'espace k et que des données codées sur l'espace k sont acquises pendant la présence des gradients $G_x$ et $G_y$.

2. Procédé selon la revendication 1, **caractérisé en ce que**
le module d'acquisition de données est répété pour l'acquisition de données d'au moins une autre couche.

3. Procédé selon la revendication 1 ou 2, **caractérisé en ce que**
le gradient magnétique $G_z$, aux fins d'un autre codage de l'espace k, est connecté au moins par tranches avant les gradients magnétiques $G_x$ et $G_y$ et présente un tracé temporel constant pendant une durée de commutation.

4. Procédé selon l'une des revendications 1 ou 2, **caractérisé en ce que**
le gradient magnétique $G_z$, aux fins d'un autre codage de l'espace k, est connecté au moins par tranches en même temps que les gradients magnétiques $G_x$ et $G_y$ et présente un tracé temporel constant pendant une durée de commutation.

5. Procédé selon l'une ou plusieurs des revendications précédentes, **caractérisé en ce que**
à l'intérieur du module d'acquisition de données, il se produit un autre codage de l'espace k par une modification de la phase d'au moins l'un des gradients magnétiques $G_x$ et $G_y$.

6. Tomographe à résonance magnétique pour quantifier le temps de relaxation longitudinale spin-réseau ($T_1$), comportant un moyen pour générer des gradients magnétiques, un moyen pour générer des impulsions haute fréquence, un moyen d'acquisition de signaux et un moyen pour générer un champ magnétique statique, **caractérisé en ce que**
une électronique de commande génère un procédé d'imagerie selon l'une des revendications 1 à 5.

7. Tomographe à résonance magnétique selon la revendication 6, **caractérisé en ce que**
il dispose de moyens pour retrier et interpoler les données acquises ainsi que de moyens permettant une reconstruction de Fourier.

Fig. 1

Fig. 2

Fig. 3

Fig. 4

Fig. 5

Fig. 6

**EP 1 740 968 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• DE 10028171 A1

**In der Beschreibung aufgeführte Nicht-Patentliteratur**

• **P. MANSFIELD ; P. G. MORRIS.** MMR Imaging in Biomedicine. Academic Press, 1982
• **P. T. CALLAGHAN.** Principles of Nuclear Magnetic Resonance Microscopy. Clarendon Press, 1991
• **E. MARK HAACKE et al.** Magnetic Resonance Imaging. Wiley-Liss, 1999
• *Journal of Magnetic Resonance,* 1992, vol. 96, 608-612
• *Magnetic Resonance in Medicine,* 1990, vol. 16, 238-245
• **D. C. LOOK ; D. R. LOCKER.** *The Review of Scientific Instruments,* 1970, vol. 41 (2), 250-251
• **W. BLOCK et al.** RARE Spiral T2-Weighted Imaging. *Mag. Res. Med,* 1997, vol. 37, 582-590
• **C. H. MEYER et al.** *Magnetic Resonance in Medicine,* 1990, vol. 15, 287 ff
• *Magnetic Resonance in Medicine,* 2003, vol. 50, 915 ff